# EUROPEAN PATENT APPLICATION

(11) **EP 2 833 393 A1**
(43) Date of publication of application: **04.02.2015**
(21) Application number: 13767655.7
(22) Date of filing: 21.03.2013
(51) Int. Cl.: H01L 21/52, H01B 1/00, H01B 1/22

(54) **CONDUCTIVE PASTE FOR DIE BONDING, AND DIE BONDING METHOD USING CONDUCTIVE PASTE FOR DIE BONDING**

(30) Priority: 29.03.2012 JP 2012075525
(71) Applicant: Tanaka Kikinzoku Kogyo K.K., Chiyoda-ku Tokyo 100-6422 (JP)
(72) Inventor: OGASHIWA, Toshinori, Hiratsuka-shi Kanagawa 254-0076 (JP); SHIOYA, Akikazu, Hiratsuka-shi Kanagawa 254-0076 (JP); MIYAIRI, Masayuki, Hiratsuka-shi Kanagawa 254-0021 (JP)
(74) Representative: Dey, Michael
(86) International application number: PCT/JP2013/057985
(87) International publication number: WO 2013/146504

(57) **Abstract**

The present invention provides a conductive paste for die bonding comprising a metal powder and an organic solvent, the metal powder comprising: one or more metal particles selected from a silver powder, a palladium powder, and a copper powder, the metal particles having a purity of 99.9% by mass or higher and an average particle size of 0.01 µm to 1.0 µm; and a coating layer made of gold covering at least part of the metal particles. The conductive paste according to the present invention can suppress the occurrence of defects such as voids in a bonded part when a semiconductor element or the like is die-bonded to a substrate.

## Description

### BACKGROUND OF THE INVENTION

### FIELD OF THE INVENTION

The present invention relates to a conductive paste applied to die bonding and flip chip bonding of a semiconductor chip to a substrate, and to a bonding method using the same. The present invention particularly relates to a conductive paste excellent in durability which prevents voids from occurring in a bonded part even after the lapse of long time at high temperatures.

### DESCRIPTION OF THE RELATED ART

As the die bonding method of various semiconductor chips to a substrate, those using a brazing filler metal are conventionally widely known. In the die bonding method, the brazing filler metal is fused to either a semiconductor chip or a substrate; the semiconductor chip is then placed on the substrate; they are heated to a temperature equal to the melting point of the brazing filler metal or higher to melt the brazing filler metal; and the brazing filler metal is then solidified. The heating temperature in this regard (bonding temperature) is set in consideration of the melting point of the brazing filler metal to be used. For example, an AuSn-based brazing filler metal has been known as a brazing filler metal generally used in the die bonding in recent years, and since the melting point of the AuSn-based brazing filler metal is about 280°C, the bonding temperature is set to a temperature of 300°C or higher in many cases.

The bonding temperature during the die bonding is preferably a low temperature. The reason for this is as follows: if the bonding temperature is set to a high temperature, thermal stress generated during cooling after bonding increases, and then a variation might occur in the electrical characteristics of a semiconductor chip. In addition, the heating during bonding itself might affect the characteristics of a semiconductor chip. Thus, in order to reduce the die bonding temperature of a semiconductor chip, as an alternative method to a conventional die bonding method with brazing, there are known die bonding methods in which a conductive paste containing a metal powder made of a conductive metal such as silver is used (Patent Documents 1 and 2).

### Prior Art Documents

### Patent Documents

Patent Document 1: Japanese Patent Application Laid-Open No. H11-26480
Patent Document 2: Japanese Patent Application Laid-Open No. 2002-158390

### SUMMARY OF THE INVENTION

### Problems to be Solved by the Invention

These die bonding methods with a conductive paste allow bonding at a lower temperature than in a conventional die bonding method with a brazing filler metal and provide sufficient bonding strength, and in addition, the handlability of the paste is satisfactory. Therefore, these methods have been more widely used in recent years.

However, according to the investigations of the present inventors, a defect may occur in the bonded part in the above die bonding method with a conventional conductive paste, in a high-temperature environment. The defect is a void occurring in a conductive paste after being cured, which is a bonded part between bonded materials. The void tends to occur in an environment where bonded members are exposed to high temperatures, and may grows with time and cause eventual peeling. Such a defect does not always occur, but naturally, it should be eliminated.

The present invention has been made against a background of the above problems and provides a conductive paste for die-bonding a semiconductor element or the like to a substrate, which can suppress the occurrence of defects as described above.

### Means for Solving the Problems

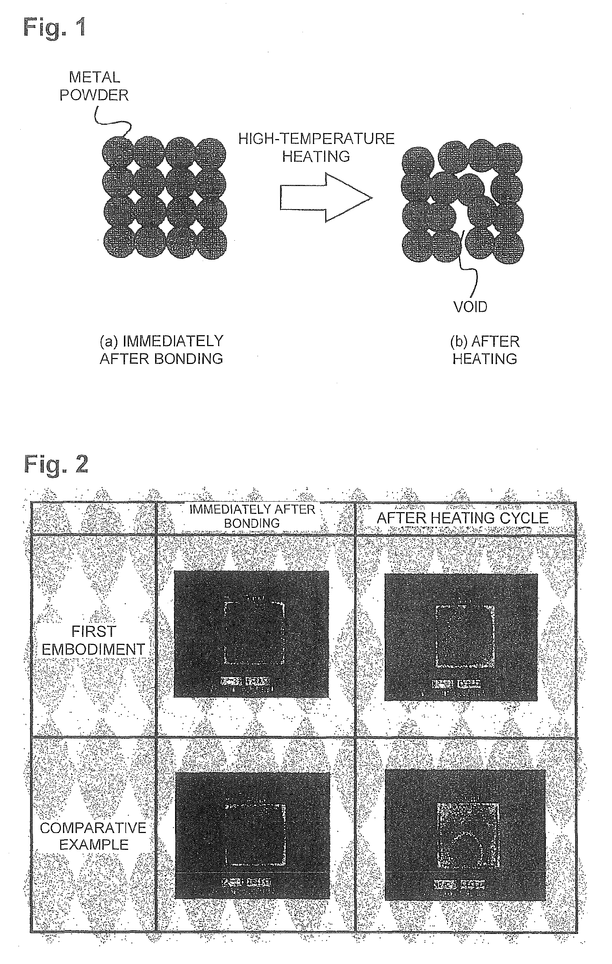

In order to solve the above problems, the present inventors first investigated the properties of the above defects occurring in the bonding process with a conventional conductive paste, and the cause of the defect occurrence. First, the investigation results will be described with reference to Fig. 1. Fig. 1 illustrates the state of a bonded part immediately after bonding in a conventional bonding process, and the state of the bonded part when it is heated to high temperatures. In the bonding process with a conductive paste, a bonded part is formed with the progress of densification due to the rearrangement of metal particles caused by the pressurization during bonding, followed by densification due to plastic deformation (shear deformation). As shown in Fig. 1(a), although the bonded part at this time is in a relatively dense state, it is in the state in which each metal particle is not completely integrated but a void remains among particles.

Then, when this bonded part undergoes high-temperature heating, diffusion among metal particles will proceed, and the metal particles will be more densely bonded. However, if this occurs uniformly among all the metal particles, the bonded part will be more densified and poses no problem, but it does not necessarily become so in practice. This is because a film made of an oxide or a sulfide is formed on the surface of metal particles. When a film of an oxide or the like is present on the surface of metal particles, the bonding state between metal particles will lack uniformity, and voids will locally occur as shown in Fig. 1(b). The present inventors have found that the variation in the bonding state between the metal particles generated in the high-temperature environment is the cause of the voids.

The following points are verified from the above investigation results. That is, the voids as described above occur when the bonded part is heated to high temperatures, and this is a phenomenon often generated in a semiconductor element used in such an environment. Moreover, if the lack of uniformity in the bonding of metal particles is caused by an oxide or a sulfide on the surface of metal particles, the non-uniform bonding is deemed to hardly occur when a conductive paste made of a metal powder excellent in corrosion resistance is used.

However, the use area of a semiconductor element cannot be limited for reasons of the defect occurrence s in a bonded part. Moreover, if the component of metal particles for a conductive paste is gold which is excellent in corrosion resistance, the above defects will not occur. The present inventors have also verified this point. However, although a metal such as silver is liable to be oxidized or sulfurized, it is excellent in conductivity and better in cost than gold, and utilization of such a metal is also required. Thus, the present inventors investigated in order to improve the corrosion resistance of the metal particles in a conductive paste of a predetermined metal to thereby suppress the occurrence of voids caused by high-temperature heating after bonding, and have reached the present invention.

Specifically, the present invention provides a conductive paste for bonding comprising a metal powder and an organic solvent, wherein the metal powder comprises one or more metal particles selected from a silver powder, a palladium powder and a copper powder having a purity of 99.9% by mass or higher and an average particle size of 0.01 µm to 1.0 µm, and a coating layer made of gold covering at least part of the metal particles.

In the present invention, a metal powder is constituted by forming a coating layer made of gold for improving corrosion resistance on the surface of metal particles made of silver, palladium, and/or copper, thereby suppressing oxidation, sulfurization, and the like of the metal powder to uniformize the bonding between particles in a bonded part when the bonded part undergoes high-temperature heating after die bonding. Hereinafter, the present invention will be described in more detail.

The metal particles constituting the metal powder in the present invention comprises one or more metal powders selected from a silver powder, a palladium powder and a copper powder having a purity of 99.9% by mass or higher and an average particle size of 0.01 µm to 1.0 µm. As the purity of the metal particles, a high purity of 99.9% by mass or higher is required, because if the purity is low, the hardness of the powder will be high, and plastic deformation will hardly occur when a bonded part is formed during die bonding. Moreover, the metal powder is required to have the average particle size as described above, because if the metal powder has a particle size exceeding 1.0 µm, a preferred proximity state is hardly developed when rearrangement has occurred during die bonding. On the other hand, 0.01 µm is defined as the lower limit of the average particle size, because if metal particles have a particle size of less than 0.01 µm, the metal particles will be easily aggregated, and the handling will be difficult. Then, the metal constituting the metal powder is any of silver, palladium, and copper because these metals have good conductivity. Then, these metals are selected because they are relatively easily corroded, and the effect of the coating layer by the present invention is developed.

Then, gold has been selected as a material for covering the metal particles because gold is excellent in corrosion resistance and effective in the suppression of corrosion of the metal particles. Here, the thickness of the coating layer is preferably 0.002 µm to 0.3 µm. This is because if the thickness is less than 0.002 µm, the effect of the coating layer will not be developed, and even if the thickness exceeds 0.3 µm, a higher effect cannot be expected, and the cost of the metal particles will be increased. Moreover, if the coating layer covers at least part of the metal particles, the effect thereof will be developed, and it is not required to cover the whole surface of all the metal particles. Even if the metal particles are partially covered, the point of contact which allows diffusion of metal particles will increase, and as a result, the variation in the bonding state between metal particles can be reduced. Specifically, it is preferred that 0.5 to 30 vol% of gold be present based on the volume of the whole metal powder.

A method for forming a thin film such as plating and sputtering can be applied as a method for forming a coating layer. The thickness of the coating layer as described above is preferably controlled in a very thin range, and for this purpose, the adoption of a method for forming a thin film such as plating is adequate. Particularly preferred is a method based on plating such as electroless plating.

The conductive paste according to the present invention is formed with dispersing the above metal powder in an organic solvent. As the organic solvent for the conductive paste, ester alcohol, terpineol, pine oil, butyl carbitol acetate, butyl carbitol, and carbitol are preferred. Examples of preferred ester alcohol-based organic solvents include 2,2,4-trimethyl-3-hydroxy-penta-isobutyrate (C₁₂H₂₄O₃). This solvent is preferred because it can be dried at a relatively low temperature.

The content of the metal powder in the conductive paste is preferably 70 to 99% by mass. If the content is less than 70% by mass, the amount of metal required for bonding will be too small to form a dense bonded part. Moreover, if the content exceeds 99% by mass, the viscosity of the paste will be too high to handle the paste without trouble.

Moreover, the conductive paste according to the present invention may contain one or more resins selected from an acrylic resin, a cellulose-based resin, and an alkyd resin in addition to the above organic solvent. When these resins are further added, the aggregation of metal powders in the conductive paste is inhibited, and a more homogeneous bonded part can be formed. Examples of the acrylic resin include a methyl methacrylate polymer; examples of the cellulose-based resin include ethylcellulose; and examples of the alkyd resin include a phthalic anhydride resin. Among them, ethylcellulose is particularly preferred.

Next, a die bonding method with the conductive paste according to the present invention will be described. The die bonding method according to the present invention is basically the same as a method of using the conventional conductive paste as described above. Specifically, it is a method for die bonding a semiconductor element or the like which is a bonding member to a substrate, the method comprising the steps of: applying the conductive paste according to the present application to the substrate or the bonding member; and arranging the bonding member on the substrate and then applying pressure and heat thereto from one direction or both directions to thereby bond the bonding member and the substrate.

The application process of the conductive paste is not particularly limited, and examples thereof include a spin coat method, a screen printing method, an ink-jet method, and a method of dropwise adding a paste and then extending it by a spatula or the like. Various methods can be used corresponding to the size of the bonded members.

Then, after a conductive paste is applied to one bonding member, the other bonding member is placed thereon, and they are heated and pressurized. The heating and pressurization forms a proximity state of mutual point contact between metal particles in the paste and between the bonding surfaces of the bonding members and the metal particles, which stabilizes the shape of the bonded part. The heating temperature is preferably 80 to 300°C, because if the heating temperature is less than 80°C, the point contact will not occur, and on the other hand, if the heating temperature exceeds 300°C, the binding between metal powders will excessively proceed to form necking among the metal powders, which strongly binds the metal particles, forming an excessively hard state. Moreover, heating exceeding 300°C may deform or thermally affect the substrate. The pressurization during bonding is preferably 0.5 MPa to 50 MPa. If the pressurization is in a range lower than 0.5 MPa, the conductive paste cannot be adhered to the whole bonded surface, and if it is in a range higher than 50 MPa, further improvement in the bonding state cannot be observed.

Moreover, in the die bonding method, an ultrasonic wave may be applied in addition to heating. Heating or a combination of heating and an ultrasonic wave accelerates the plastic deformation and binding of metal powders and can form a stronger bonded part. When an ultrasonic wave is applied, the conditions for applying the ultrasonic wave preferably include an amplitude of 0.5 to 5 µm and an application time of 0.5 to 3 seconds. This is because excessive ultrasonic application damages the bonding members. The heating and ultrasonic application in the die bonding step may be applied to at least the bonded part from the purpose thereof, or may be applied to the whole bonding members. A simple method of heating includes utilizing heat transfer from a tool for pressurizing bonding members. Similarly, a simple method of applying an ultrasonic wave includes ultrasonic oscillation through a tool for pressurizing bonding members.

### Effect of the Invention

As described above, the conductive paste for die bonding according to the present invention can maintain the soundness of a bonded part without generating and growing voids even under high-temperature heating, and can improve the durability of the bonded part. According to the present invention, various bonding members can be bonded at a relatively low temperature, and the bonding members can be protected from the thermal stress in the cooling process after bonding. Therefore, the present invention is useful for bonding, to a substrate, a semiconductor chip or the like which has a concern of the influence of thermal stress and can be applied to the die bonding, flip chip bonding, and the like. The present invention is particularly useful for the die bonding of a power device and the like since the bonded part is stable even under high temperatures.

### BRIEF DESCRIPTION OF THE DRAWINGS

Fig. 1 is a schematic diagram illustrating the state of the bonded part in the bonding process of using a conventional conductive paste.
Fig. 2 is a SAT observation photograph of the bonded part in First Embodiment and Comparative Example.
Fig. 3 is a SEM photograph of the cross section of the bonded part in Comparative Example after 1000 cycles.
Fig. 4 is a SAT observation photograph of the bonded part in Comparative Example after heat treatment for 200 hours.
Fig. 5 is a SEM photograph of the observation of the cross section of the bonded part in Comparative Example after heat treatment for 200 hours.

### DETAILED DESCRIPTION OF THE PREFERRED EMBODIMENTS

First Embodiment: In this embodiment, a conductive paste in which a metal powder obtained with forming a coating layer made of gold on metal particles was dispersed was prepared. The conductive paste was used to die-bond an Si chip to a semiconductor substrate, and the soundness of the bonded part was investigated.

Production of conductive paste: Gold was coated as a coating layer on a silver powder (average particle size: 0.3 µm) having a purity of 99.9% by mass, produced by wet reduction. The coating layer was formed by electroless plating. Specifically, a non-cyanide displacement electroless gold plating solution was used as a plating solution. A plating solution containing 5 g/L of gold sulfite in terms of gold was used as a gold source. As a pretreatment, oxides and sulfides on the surface of silver powder were removed with dilute sulfuric acid. The resulting silver powder was charged into a plating solution set at a plating temperature of 70°C as a plating condition and was treated for 1 hour to form a gold layer on the surface of the silver powder. The coating layer had an average thickness of 0.01 µm. The thickness of the coating layer was calculated based on the results of measurement of gold film thickness when a silver plate was plated with gold under the same conditions as above by an X-ray fluorescence (XRF) method for the measurement of film thickness.

Then, the metal powder produced in this way was mixed with ester alcohol (2,2,4-trimethyl-3-hydroxy-penta-isobutyrate (C₁₂H₂₄O₃)) as an organic solvent to produce a conductive paste (the content of the metal powder was 90% by mass).

Bonding test: A DBC substrate (Direct Bonding Copper substrate), which has been prepared with bonding a copper foil (0.15 mm) on a ceramic and has a thickness of 0.6 mm, and a Si chip as a bonding member were prepared. Sputtered films of Ti (50 nm), Pt (50 nm), and Au (200 nm) have been previously formed on the surfaces of the copper foil on the DBC substrate and the Si chip.

The above conductive paste was applied to the DBC substrate, and then the Si chip (2 mm square) was placed thereon. They were pressurized at 5 MPa, then heated to 300°C at a temperature rising rate of 1°C/minute, and held for 10 minutes to be bonded.

Comparative Example: In the conductive paste production process in First Embodiment, the silver powder as it is without being plated with gold was mixed with an organic solvent to produce a conductive paste. Then, the Si chip was bonded to the DBC substrate in the same steps as in First Embodiment.

Evaluation test of bonded part (heating cycle test): DBC substrates with Si chips which were die-bonded in First Embodiment and Comparative Example were subjected to a heating cycle test to investigate the presence or absence of the occurrence of voids and peeling. In this test, the substrate was held at -40°C for 5 minutes and then held at 200°C for 5 minutes. This operation was defined as one cycle, and the operation was repeated 1000 cycles. The surfaces of the substrate before and after the test were observed with a scanning acoustic tomograph (SAT). Moreover, the cross section of the chip/substrate bonded part after 1000 cycles was observed.

Fig. 2 shows the results of SAT observation in First Embodiment and Comparative Example after the heating cycle. In Comparative Example, the occurrence of linear voids was observed from the early stage of the cycle (zero time), and peeling occurred from the periphery of the Si chip after 1000 cycles. On the other hand, in First Embodiment, the occurrence of linear voids was hardly observed in the early stage of the cycle, and only a small amount of peeling was observed from the periphery of the Si chip after 1000 cycles.

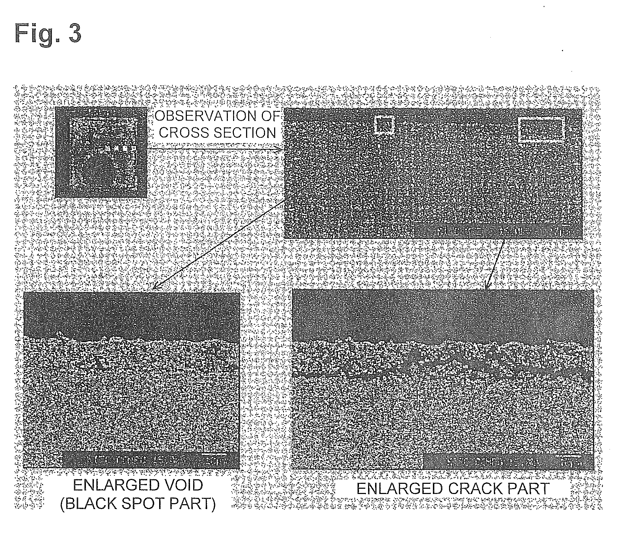

Fig. 3 is a SEM photograph of the cross section of the bonded part in Comparative Example after 1000 cycles. As shown in Fig. 3, the cracks from the Si chip periphery have propagated through the bonding material, and this probably leads to the peeling of the chip. Moreover, since a large number of voids are present in the vicinity of the tip of the cracks, it was estimated that these voids caused the cracks.

Evaluation test of bonded part (continuous heating test): Next, DBC substrates with Si chips which were die-bonded in First Embodiment and Comparative Example were checked for the presence or absence of voids when they were heated for a long time (200 hours). In this test, each substrate was heated at 300°C for 200 hours, and the substrate after heating was subjected to SAT observation and observation of cross section.

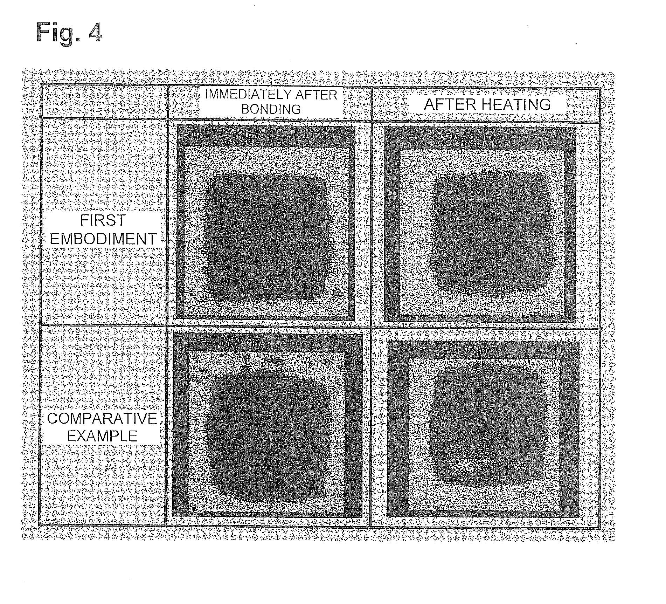

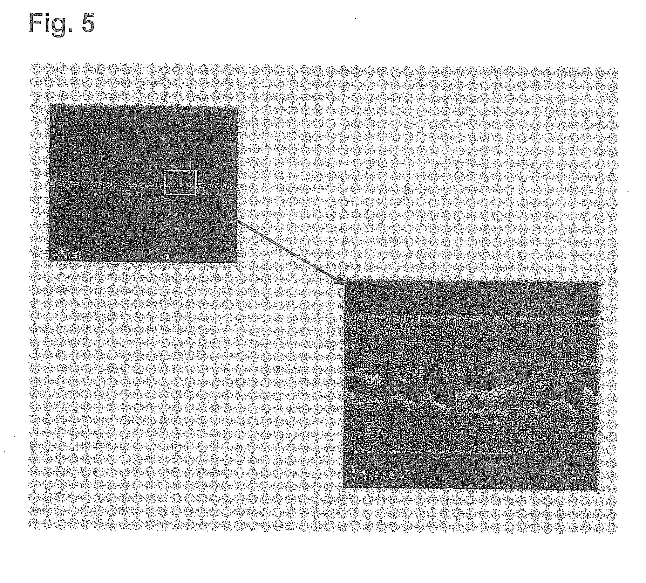

Fig. 4 shows the results of SAT observation after the continuous heating test. In Comparative Example, peeling had occurred in the lower half of the chip after the lapse of 200 hours. On the other hand, peeling was not observed in the substrate in First Embodiment. Moreover, Fig. 5 shows the results of observation of the cross section of the bonded part in Comparative Example after heating. It was found that a continuous void was formed as a result of separation of silver powders that should be located in the center of the bonded part.

From the results of two heating tests on the bonded part as described above, it is deemed that the occurrence of voids will be suppressed with forming a gold layer to improve the adhesion of silver powders, thereby maintaining the soundness of the bonded part. The occurrence of voids in Comparative Example is similar to the model shown in Fig. 1(b), and it has been verified that when a film of an oxide or the like is formed on the surface of metal particles, the bonding state between metal particles will lack uniformity, resulting in the occurrence of voids in a high-temperature environment.

Second Embodiment: In this embodiment, there were prepared two types of metal powder (silver powder, copper powder) in which the thickness of the coating layer was adjusted. Conductive pastes were produced from these metal powders, and the soundness of the bonded part depending on the proportion of the coating layer was investigated. The metal powders were produced in the same manner as in First Embodiment, in which the conditions of gold plating which is a coating layer were changed so that the coating layer had a thickness of 0.001 µm, 0.002 µm, 0.005 µm, 0.05 µm, 0.1 µm, or 0.3 µm. The thickness of the coating layer was adjusted with changing plating conditions, in which the gold concentration of the plating solution was set to 2 to 10 g/L; the plating temperature was set to 60 to 90°C; and the plating time was set to 1 to 2 hours. Moreover, a conductive paste was also produced in the same manner as in First Embodiment. Moreover, the Si chip was similarly bonded to the DBC substrate. The soundness of the bonded part between the Si chip and the DBC substrate was evaluated with measuring the shear strength of the bonded part of the substrate before and after heating at 300°C for 200 hours with a bonding tester (a pressure loading of 5 MPa). The results of the measurement are shown in Table 1.

**[Table 1]**

| Coating layer thickness (µm) | Shear strength (MPa) | | | |
|---|---|---|---|---|
| | Silver powder | | Copper powder | |
| | Immediately after bonding | After heating | Immediately after bonding | After heating |
| 0.001 | 28 | 5 | 24 | 8 |
| 0.002 | 28 | 27 | 25 | 24 |
| 0.005 | 30 | 33 | 27 | 30 |
| 0.05 | 29 | 40 | 26 | 35 |
| 0.1 | 31 | 42 | 25 | 36 |
| 0.3 | 30 | 41 | 27 | 36 |

Table 1 reveals that, in the silver powder having a coating layer (gold layer) thickness of 0.001 µm, the shear strength of a bonded part is greatly reduced with heating. On the other hand, the reduction in shear strength is not observed in the silver powder having a gold film thickness of 0.002 µm or more. Rather, the shear strength tends to increase when the thickness is 0.005 µm or more. This is probably because the bound part is further densified by high-temperature heating, and it is deemed that such densification is achieved with forming a coating layer. The same tendency as above is obtained also in the case of copper powder, and it is deemed that a bonding state excellent in stability has been able to be ensured with forming a gold film having a predetermined film thickness or more. Note that when a thick gold film is formed, the cost of the resulting metal particles will increase. Therefore, when a cost aspect is taken into consideration, it is deemed that the thickness of the coating layer is preferably 0.002 µm to 0.3 µm, more preferably 0.002 µm to 0.05 µm.

### Industrial Applicability

The conductive paste for die bonding according to the present invention can form a bonded part in which voids hardly occur and grow even when the bonded part undergoes high-temperature heating. The present invention can be applied to the die bonding, flip chip bonding, and the like of a semiconductor chip or the like, and in particular, it is useful for the bonding of a power device which is used in a high-temperature environment.

## Claims

1. A conductive paste for die bonding comprising a metal powder and an organic solvent, wherein
the metal powder comprises one or more metal particles selected from a silver powder, a palladium powder and a copper powder having a purity of 99.9% by mass or higher and an average particle size of 0.01 µm to 1.0 µm, and a coating layer comprising gold covering at least part of the metal particles.

2. The conductive paste for die bonding according to claim 1, wherein the thickness of the coating layer is 0.002 µm to 0.3 µm.

3. The conductive paste for die bonding according to claim 1 or 2, wherein the content of the metal particles constituting the coating layer is 70 to 99% by mass based on the weight of the paste.

4. A method for die bonding a bonding member to a substrate, the method comprising the steps of:
applying the conductive paste defined in any one of claims 1 to 3 to the substrate or the bonding member; and
arranging the bonding member on the substrate and then applying pressure and heat thereto from one direction or both directions to thereby bond the bonding member and the substrate.

5. The die bonding method according to claim 4, wherein the heating temperature during bonding is 80 to 300°C.
